# EUROPEAN PATENT APPLICATION

(11) **EP 4 815 637 A1**
(43) Date of publication of application: **30.09.2026**
(21) Application number: 25167011.3
(22) Date of filing: 28.03.2025
(51) Int. Cl.: H05K 1/02, H05K 3/46

(54) **ELEMENT WITH PROTRUDING LIP, COMPONENT CARRIER, AND MANUFACTURE METHOD**

(71) Applicant: AT & S Austria Technologie & Systemtechnik Aktiengesellschaft, 8700 Leoben-Hinterberg (AT)
(72) Inventor: CHRISTANDL, Robert, 8700 Leoben (AT); PODHORSKY, Jan, 8700 Leoben (AT); GREITNER, Gernot, 8621 Thörl (AT)
(74) Representative: Dilg, Haeusler, Schindelmann Patentanwaltsgesellschaft mbH

(57) **Abstract**

There is described an element (100) for a component carrier (200), comprising a body (110) defining two opposed main surfaces (111, 112) and a lateral wall (115) between said two opposed main surfaces (111, 112);
wherein the lateral wall (115) defines the peripheral surface (116) of the body (110); and
wherein the lateral wall (115) comprises an intermediate protruding lip (120) extending along at least a portion of said peripheral surface (116).

## Description

### Field of the Invention

The invention relates to an element for a component carrier, comprising a body defining two opposed main surfaces and a lateral wall between said two opposed main surfaces, wherein the lateral wall defines the peripheral surface of the body, and wherein the lateral wall comprises an intermediate protruding lip extending along at least a portion of said peripheral surface. The invention further relates to a component carrier comprising the element, a method of manufacturing the element, and a method of manufacturing the component carrier with the element.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

In particular, providing a functionality (for example a thermal, electric, mechanical or magnetic functionality) to a component carrier, e.g. in form of an inlay, may still be considered a challenge. The mechanical functionality may hereby include a mechanical integrity, in particular durability (oxidation and corrosion resistance) and structural support (reinforces component carrier and enhancing mechanical stability under stress).

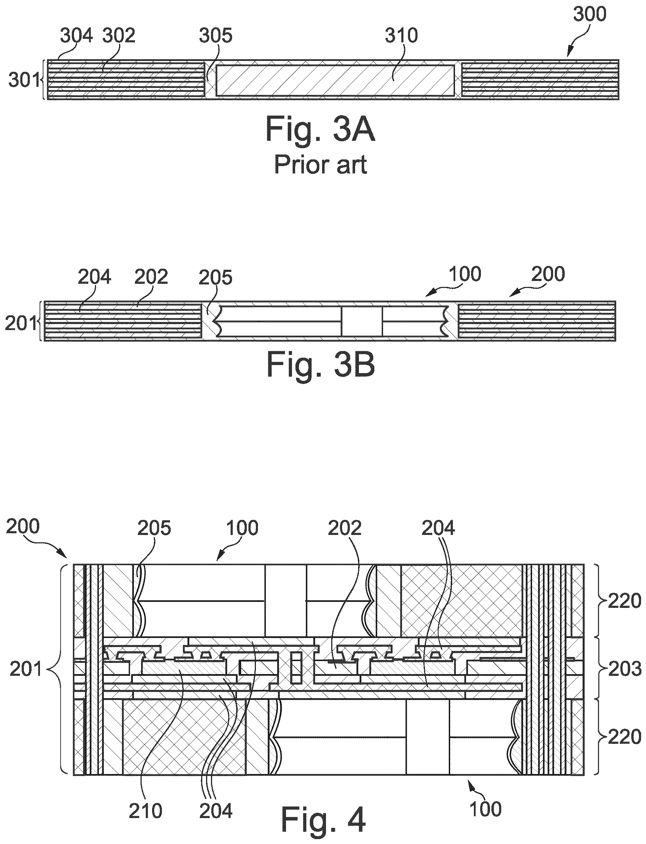

**Figure 3A** illustrates a conventional circuit board 300 with a stack 301 that comprises electrically conductive layers 302 and electrically insulating layers 304. A cavity has been formed in the stack 301 and a thermal device (here a copper block) 310 has been placed in the cavity. Afterwards, the thermal device 310 has been encapsulated by a resin material 305 in the cavity. The thermal device 310 serves the purpose of dissipating heat from the circuit board 300. Such copper inlays are generally mechanically processed, e.g. by routing.

However, mechanical processing can have drawbacks, for example a routing process may lead to cracking of the thermal device material. Furthermore, the mechanical processing generally produces straight sidewalls (see in the Figure), thereby decreasing adhesion (at the contact area) between the inlay (e.g. a copper block) and the resin material in the cavity. These drawbacks may finally lead to a decrease in the component carrier performance.

### Summary of the Invention

There may be a need to provide a functional element for a component carrier in an efficient and reliable manner.

According to an exemplary embodiment of the invention, an element, a component carrier, and methods of manufacturing are described.

According to an aspect of the invention, there is described an element (in particular an inlay, e.g. a thermal copper element) for a component carrier (e.g. a printed circuit board), comprising a body defining two opposed main surfaces (e.g. an upper main surface and a lower main surface) and a lateral wall (sidewall) between (connecting) said two opposed main surfaces.

The lateral wall defines the peripheral surface (shape, profile) of the body, and the lateral wall comprises an intermediate protruding lip (e.g. a nose, a central protrusion, etc.) extending along at least a portion of said peripheral surface (in particular vertically intermediate with respect to the thickness of the element).

According to a further aspect of the invention, there is described component carrier comprising a (multi-layer) stack comprising at least one electrically insulating layer structure (e.g. a resin layer) and at least one electrically conductive layer structure (e.g. a patterned copper foil), wherein the component carrier further comprises at least one element as described above (e.g. embedded and/or surface-mounted).

According to a further aspect of the invention, there is described a method of manufacturing an element (e.g. as described above), the method comprising:
i) providing a body preform (e.g. a panel), in particular having a plate-like shape, that comprises a first main surface and an opposed second main surface;
ii) removing first material in the thickness direction (z+) from the first main surface; and (at the same time or subsequently)
iii) removing second material in the opposed thickness direction (z-) from the second main surface, so that
iv) a body is provided, wherein a lateral wall is formed between the first main surface and the second main surface that defines the peripheral surface of said body, and wherein the lateral wall comprises an intermediate protruding lip (in particular being a footprint of the material removal form opposed sides) extending along at least a portion of said peripheral surface.

According to a further aspect of the invention, there is described a method of manufacturing a component carrier, the method comprising:
i) providing a stack comprising at least one electrically conductive layer structure and at least one electrically insulating layer structure; and
ii) assembling, in particular embedding and/or surface-mounting, an element as described above and/or manufactured as described above to the stack.

In the context of the present document, the term "element" may particularly denote a physical component that comprises a body. Such an element can be configured for example as an inlay, in particular for a component carrier. The element may be a functional element that can provide a specific functionality, e.g. to a component carrier. For example, the functionality may be thermal (e.g. heat sink), electric (e.g. for strong currents), mechanical (e.g. durability, structural support) or magnetic (e.g. induction). The body of such an element may comprise two opposed main surfaces, connected by a lateral surface/wall. Thus, the element may be plate-like shaped (e.g. rectangular), wherein the main surfaces (of such a plate) are oriented along the horizontal directions (horizontal plane, planar extension) and the lateral wall is oriented along the vertical direction or thickness direction. The element may comprise an inorganic or organic material, e.g. a metal (e.g. a copper foil) or a resin (e.g. prepreg), depending on the desired application. Additionally or alternatively, the inorganic material of the element may comprise ceramic and/or glass. Preferably, the metal of the element may comprise copper. Additionally or alternatively, the metal of the element may comprise titanium, nickel, chromium and/or aluminium. Such an element may be characterized by a specific manufacture process that leaves as a footprint an intermediate protruding lip.

In the context of the present document, the term "intermediate protruding lip" may in particular denote a structural feature at the lateral wall and/or the peripheral surface of an element as described above. The intermediate protruding lip may be a footprint of a manufacture process, for example removing material from the two opposed main surfaces respectively. In an embodiment, the intermediate protruding lip may have a rounded shape, e.g. convex. In another embodiment, the intermediate protruding lip may have a pointed edge, e.g. two straight portions with a vertex in between. In an embodiment, the intermediate protruding lip may be arranged (in the vertical direction) between two concave portions and/or undercuts and/or two boundary profiles. The intermediate protruding lip may be vertically intermediate with respect to the thickness of the element (i.e. along the vertical direction). Further, the intermediate protruding lip may be internal with respect to the external (main) surfaces of the element. In an embodiment, the intermediate protruding lip at least partially surrounds the element, in particular in a planar/horizontal direction. Preferably, the intermediate protruding lip may be monolithically connected to the lateral wall and/or the peripheral surface of the element as describe above.

In the context of the present document, the term "main surface" may particularly denote a surface that is oriented along a plane in parallel to the directions of main extension (planar extension, horizontal plane, x-y) and perpendicular to a thickness direction (vertical direction, z). In an embodiment, the element may comprise two directions of main extension (length, width) in the horizontal direction and a perpendicular extension (which is not a main extension) in the vertical direction (thickness). In an embodiment, such a main surface of the element may be the external surface. For example, a first main surface may be the upper external surface and a second main surface may be the (opposed) lower external surface.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive layer structures and at least one electrically insulating layer structure.

In the context of the present document, the term "layer structure" may particularly denote a continuous layer, a patterned layer or a plurality of nonconsecutive islands (discontinuous) within a common plane, and it may perform the function of electrical conductivity and/or electrical insulation. A layer structure may also comprise an interconnection structure which protrudes from a planar surface of the layer structure.

According to an exemplary embodiment, the invention may be based on the idea that a functional element (e.g. a copper inlay) for a component carrier can be provided in an efficient and reliable manner, when the element is manufactured to comprise a body with two opposed main surfaces and a lateral wall in between, wherein the lateral wall defines a peripheral surface and comprises an intermediate protruding lip that extends partially along the peripheral surface.

The described element can be used in a design-flexible manner for a plurality of different functionalities, in particular regarding a component carrier. For example, the element may be configured as a metal/copper inlay to be embedded in the component carrier as a heat sink. In another example, the element may comprise magnetic material and may be used to enhance induction in the component carrier.

In comparison to prior art examples (see e.g. Figure 3A above), the element does not have straight side walls, but a peripheral surface with the intermediate protruding lip. The peripheral surface may also comprise further structural features such as boundary portions, an undercut, or a concave portion (see further below). These additional structural features may increase the adhesion between the element and the encapsulation/embedding resin of the component carrier in a cavity. Illustratively spoken, the intermediate protruding lip may serve as a physical and/or mechanical interaction portion, for example an anchor, in the resin material, thereby increasing adhesion, mechanical interaction and stability.

The intermediate protruding lip may increase the stability in the component carrier; there may be less resin to fill, and thinner layers may be applied. Since the intermediate protruding lip is (essentially) centered in the vertical direction of the lateral wall, the stability-increasing functionality may be maximized. This measure may also enable the provision of a thinner/thicker element, depending on the desired application. In an example, the stability of the element/inlay may be increased in a component carrier cavity due to directed resin flow caused by the intermediate protruding lip. Further, in a specific example, a stronger connection between the element and an electrically insulating layer structure, for example prepreg, may be enabled due to double joint formation and surface treatment of edges. In an embodiment, the stability may be enhanced due to the enlarged contact surface between the element and the electrically insulating material (prepreg) and the mechanical locking caused by uneven surfaces (e.g. higher roughness) of the lateral wall (which may comprise the intermediate protruding lip and the two concave portions).

Such an intermediate protruding lip may be a footprint of a manufacture process, in which material is removed from the first main surface and the opposed second main surface (i.e. material removal from opposite directions). In this manner, the intermediate protruding lip may remain as a relic, since the material removal strength is becoming weaker from the main surface towards the center of the body.

In a preferred embodiment, the material removal may be done by etching and free of mechanical processing. For example, the routing step of Figure 3A may be replaced by chemical etching. Such an etching step may be advantageously burr-free. The manufacture process time may be significantly shortened and better dimension tolerances compared to mechanical processing may be achieved.

In an embodiment, the described etching may have at least one of the following advantages compared to a mechanical process:
i) process-cost of routing tools eliminated,
ii) elimination of high pressure rinse after routing,
iii) due to shorter process time with etching: decrease of process time and loading of routing equipment (bottle-neck process),
iv) lower scrap ratio due to better control of dimension tolerances
v) no foreign material created by the routing tool.

### Exemplary Embodiments

In an embodiment, the element comprises or consists of a thermally/electrically conductive material. A thermally conductive material may provide the advantage of a thermal functionality, e.g. dissipating heat and/or serving as a heat sink. Such an element with a thermal functionality may be used for example in the environment of processors (e.g. a CPU), where a high amount of heat is produced. An electrically conductive material may provide the advantage of an electric functionality (enabling efficient signal transmission and power delivery), e.g. serving for the high current transport in power applications. In a further example, a material may be thermally and electrically conductive at the same time, e.g. copper.

In an embodiment, the element comprises or consists of an inorganic material, in particular at least one of metal (in particular copper or aluminum), ceramic, glass. Depending on the desired application, a large variety of different materials may be applied for the element. In an embodiment, the intermediate protruding lip may be produced during the manufacture process (in particular using etching) for many different materials. While in case of metal, an acid like copper chloride may be suitable, hydrofluoric acid may be used for glass.

In an embodiment, the element comprises or consists of an organic material, in particular a resin, more in particular a reinforced resin, more in particular a fiber-reinforced resin or a fiber-free reinforced resin. This may provide the advantage that also a typical component carrier/stack material may be directly applied, thereby e.g. increasing the adhesion between encapsulation material and the material of the element. In an embodiment, the element may comprise a (fully) cured resin material (like a core) that is embedded in a component carrier for stabilization and/or for electric insulation. In an embodiment, plasma etching may be used to remove such organic material.

In an embodiment, the element comprises or consists of a porous material, in particular polyimide or an aerogel. This may provide the advantage of an efficient insulation functionality. A porous material may have a very low heat dissipation capacity and may thus serve as a highly reliable insulation material. Polyimide may be used to provide the porous material. This may provide the advantage that a material with high flexibility is used that can be suitable for specific applications. Additionally or alternatively, the element may comprise a porous material comprising metal, for example a copper foam. This may reduce the weight of the stack, while still showing a reliable performance in term of thermal conductivity. Such application may be preferably used in the field of aviation and/or aerospace technology.

In an embodiment, the element is configured as or configured for at least one of: a printed circuit board, an IC substrate, an interposer, a bridge element. This may provide the advantage that the element can be applied for a large variety of technically/economically important devices. See the detailed description of PCB, IC substrate and interposer further below.

In the context of the present document, the term "bridge element" may in particular refer to any element that may function as an electric interconnection between (active/passive) components, in particular electric/electronic components. In an example, the bridge element may require at least two (exposed) electrically conductive terminals to connect respectively to the components. In a more sophisticated example, the bridge element may comprise a plurality of terminals for (inter-) connecting two or more components. The electrically conductive terminals (preferably these terminals are exposed at the same main surface (top main surface) of the bridge element) may be interconnected by an electrical interconnection arranged in the bridge element. Electrically conductive terminals and electric interconnection may hence be arranged in a "U"-shape, when seen in a (specific) cross-section of the bridge element. In particular, the bridge element may comprise a plurality of "U"-shapes, whereby a larger "U" surrounds a smaller "U". The (organic or inorganic) bridge element may include further structures with functionalities beyond the interconnection between component, for example resistance measurements, ground, thermal dissipation, etc.

In an embodiment, the intermediate protruding lip has a rounded shape, in particular a convex shape, in/along the vertical cross-section (along the vertical direction z, thickness direction). Depending on the manufacture process, the intermediate protruding lip may have a rounded shape (convex, extending away from the lateral wall) or edged/angular (e.g. with a vertex). In case of a rounded shape, adhesion to an embedding material in a component carrier cavity may be improved. For example, resin may flow around the rounded (convex) shape. In this manner, the protruding lip may separate the resin flow and enable homogenous distribution of resin.

In an embodiment, the intermediate protruding lip is delimited by two concave portions (along the thickness direction z). In an embodiment, the intermediate protruding lip is arranged between the two concave portions, in particular along the thickness direction. In an embodiment, the intermediate protruding lip may be arranged, along the extension of the vertical direction (extension of the lateral wall), centered between an upper concave portion and a lower concave portion.

In an embodiment, wherein the intermediate protruding lip comprises a convex shape, there may be (from top to bottom) a concave portion, a convex portion, and another concave portion. In a further embodiment, wherein the intermediate protruding lip comprises a pointed edge (vertex), there may be a peripheral surface shaped like the digit "3". The concave portions may enable resin in a component carrier cavity to flow into the hollow spaces, thereby improving adhesion between the embedded element and embedding material (resin).

In an embodiment, the two concave portions are similar or different one to each other. Depending on the manufacture process and/or a specific application, one of these embodiments may be preferable. For example, when more material is removed from a first (upper) main surface than from a second (lower) main surface, the upper concave portion will be larger than the lower concave portion. In an embodiment, wherein the material removal from the first main surface and the second main surface is (essentially) similar, the concave portions may also have a comparable/similar size (e.g. volume).

In an embodiment, the intermediate protruding lip may advantageously separate the resin flow into the upper concave portion and the lower concave portion.

In an embodiment, the intermediate protruding lip comprises two straight portions directed towards the external vertex of the intermediate protruding lip. In this embodiment, the intermediate protruding lip may not comprise a rounded shape but instead a pointed edge or vertex. Such a vertex may be present between two straight portions that extend/point away from the lateral wall. Depending on the desired application, such a shape may be an alternative or even preferable to a rounded shape. For example, the intermediate protruding lip may serve as an efficient and robust anchor in embedding (resin) material. Thereby, stability and performance of a component carrier may be increased.

In an embodiment, the peripheral surface has (essentially) the shape of the digit 3, in particular along the thickness direction. Such a structural feature may be obtained, when two concave portions with a pointed edge (vertex) in between are generated during the manufacture process. While the concave portions may function as hollow spaces into which an embedding (resin) material may flow, the pointed edge may serve as an anchor in the embedding material and may distribute the resin flow. Therefore, this structure may provide the advantage of an increased adhesion and stability.

In an embodiment, a boundary profile is defined by the lateral wall and the respective main surface of the body. For example, a first boundary profile may be defined by an upper part of the lateral wall and the first main surface. In a further example, a second boundary profile may be defined by a lower part of the lateral wall and the second main surface. In an embodiment, the first boundary profile may be formed as an elongation (planar extension) of the first main surface and/or the second boundary profile may be formed as an elongation (planar extension) of the second main surface. The boundary profile may be seen, in an example, as a small protruding lip, for example a first upper protruding lip and/or a second lower protruding lip. In an embodiment, the boundary profile may serve (comparable to the intermediate protruding lip) as an anchor in embedding material, thereby increasing stability in a component carrier. Further, the boundary profile may distribute the resin flow into the concave portion(s).

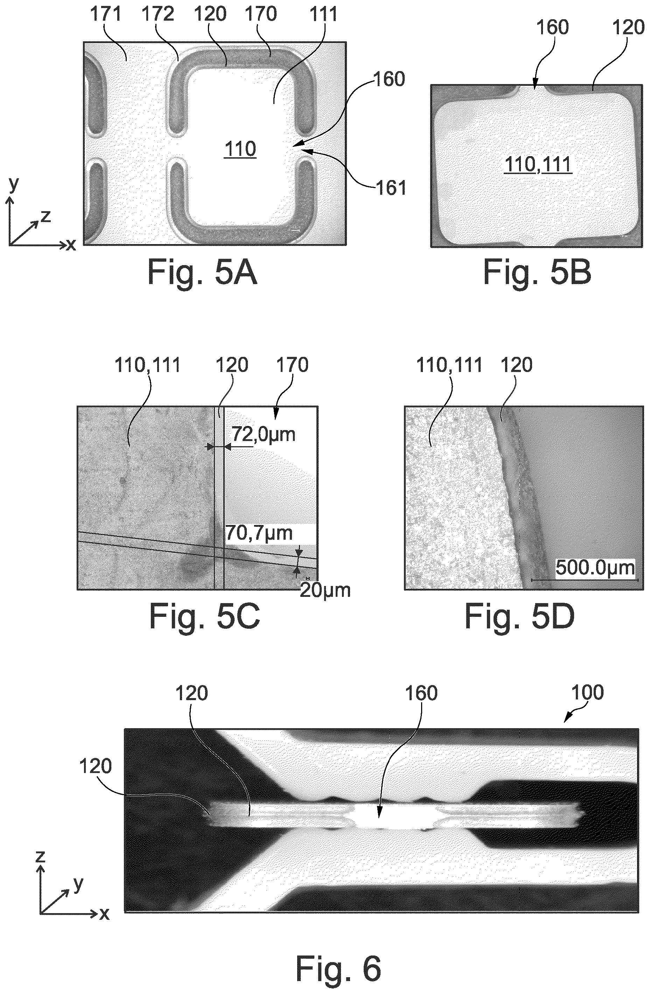

In a further embodiment, the boundary profile may be a footprint of the manufacture process: the main surface of a (planar) body preform (e.g. a panel) may be covered by a protection layer (etchant-resistant layer, e.g. a screen printed mask, or photo developable dry film). During a subsequent chemical etching process, material (unprotected by such etchant-resistant layer) of the preform will be at least partially (in particular fully) removed to form an opening in the body preform (compare e.g. Figure 5A) (in other words, material from the preform is removed to at least partially create the final shape of the element). Since the first/second main surface is/are covered by the protection layer, the boundary profile will remain well protected from the etchant. However, as a result of etching, controllable undercut may be formed between the respective boundary profiles because those areas (openings in preform) are not protected by the protection layer.

In an embodiment, (one or each of) the boundary profile(s) is associated to a further protruding lip that extends along at least a portion of the peripheral surface. Preferably, two boundary profiles may be provided each one associated to the respective main surface of the body and the lateral wall. Each of the boundary profiles may be associated to a further protruding lip that extends along at least a portion of the peripheral surface. As described above, such a further protruding lip may be smaller than the intermediate protruding lip but may also serve the advantageous purpose of increasing stability/adhesion since it is configured as a mechanical barb.

In an embodiment, (one or each of) the boundary profile(s) is vertically aligned with the respective main surface, in particular configured as a planar extension of the respective main surface. Such a structure may be a footprint of a manufacture process that applies a protection layer on the respective main surface.

In an embodiment, (one or each of) the boundary profile(s) is at a vertical position internal with respect to the respective main surface. Depending on the desired application, such a structure may be advantageously used, especially when being functionalized.

In an embodiment, (one or each of) the boundary profile(s) defines rounded a protrusion/protrusions. Like the intermediate protruding lip, the boundary profiles (further protruding lips) may be formed with a rounded shape, e.g. a convex shape. Such a structure may increase adhesion to an embedding material.

In an embodiment, the boundary profiles are associated to both main surfaces of the body. For example, the body may comprise at least one first boundary profile at the first main surface and at least one second boundary profile at the second main surface. This may provide the advantage that the stability may be increased and/or both main surfaces may be processed in the same manner, in particular by an etching process that uses a protection layer on the respective main surface(s).

In an embodiment, the size, in particular the planar extension, of the boundary profile (further protruding lips) is smaller than the size, in particular planar extension, of the intermediate protruding lip. Preferably, the size, in particular the planar extension, of one or each of the boundary profiles (further protruding lips) may be smaller than the size, in particular planar extension, of the intermediate protruding lip. In other words, the intermediate protruding lip extends farther away from the lateral wall than the boundary profiles (further protruding lips). This structural feature may be the footprint of a manufacture process that generates the biggest part of remaining material in the center (when viewing the vertical direction). Since the largest extension/protrusion is centered in the vertical direction, an optimized adhesion/stability in embedding material and/or regular distribution of said embedding material may be achieved.

In an embodiment, the boundary profile defines an undercut in the thickness direction. In an embodiment, the undercut at least partially overlaps with the respective concave portion(s). Preferably, one or each of the boundary profiles may define an undercut in the thickness direction. In an embodiment, the undercut at least partially overlaps with the respective concave portion(s). Such an undercut may be formed (in the thickness/vertical direction) between the intermediate protruding lip and the respective boundary profile. As discussed above, the undercut may be the result of a manufacture process that etches away material from the main surface. Since the main surface may be covered by a protection layer, the etchant will remove more material below the respective protected main surface. In an embodiment, the concave portion is formed between the respective main surface and the intermediate protruding lip. Accordingly, there may be an overlap (partially or fully) of the concave portion and the undercut (e.g. they may interface with each other). Comparable to the concave portion, the undercut may provide the advantage of a hollow space into which embedding resin material can flow, thereby increasing stability.

In an embodiment, the planar extension (x, y) of one of the main surfaces defined by the boundary profile is different from the planar extension (x, y) of the other one of the main surfaces defined by a respective other boundary profile. This structural feature may be a footprint of a manufacture process in which more material is removed from one main surface than from the other main surface. Additionally or alternatively, different protection layers (e.g. different thicknesses) may be applied to the respective main surfaces.

In an embodiment, the intermediate protruding lip is centered or decentered in the thickness direction (along the lateral wall) of the body. In the embodiment of the centered intermediate protruding lip, comparable/similar material removal from the first/second main surface may have been applied. In the embodiment of the decentered intermediate protruding lip, different material removal from the first/second main surface may have been applied. Depending on the application, a centered or decentered intermediate protruding lip may be preferable, e.g. depending on the layers of the stack that surround the cavity for embedding the element therein.

In an embodiment, the intermediate protruding lip has a non-constant vertical position along the respective extension of the peripheral surface. Such a variance may reflect a specific manufacture process. Additionally or alternatively, the non-constant vertical position of the intermediate protruding lip may enhance the spatial interaction of the lip with the adjacent electrically insulating layer structure, in particular the material which is embedding the element.

In an embodiment, the body has a thickness range (in the vertical direction z) from 400 µm to 2000 µm, in particular from 500 µm to 1000 µm. This may provide the advantage that a comparably thick body can be applied as the element. Conventionally, such a high thickness (e.g. of a metal) is considered too large for an etching process. Accordingly, such thick structures are normally mechanically processed, e.g. by routing. It has been surprisingly found by the inventors that even an element with such a high thickness can be efficiently processed by etching. In particular, first material is removed from a first main surface and second material is removed from an opposed second main surface, thereby the remaining structure of the element after etching yielding the intermediate protruding lip in the middle along the vertical direction, due to the successively weaker removal strength from the main surface towards the center of the body. In this manner, even a thick copper panel (e.g. 800 µm) can be efficiently and reliable processed by etching.

In an embodiment, the intermediate protruding lip has a thickness range (z) from 300 µm to 600 µm. In an embodiment, the intermediate protruding lip has a thickness range from 30% to 80% with respect to the total thickness of the body. This may provide the advantage that the intermediate protruding lip comprises a certain size/length/volume, thereby functioning as an efficient anchor and/or flow-distribution means in embedding material.

In an embodiment, the roughness of the intermediate protruding lip is different from the roughness of at least one of the main surfaces of the body. For example, the roughness of the intermediate protruding lip may be higher, thereby increasing adhesion to an (insulating) embedding material. The roughness may be caused by the material removal process, in particular etching. In an embodiment, the main surface(s) may be smoother because they may be protected during etching by a protection layer.

In an embodiment, the intermediate protruding lip partially/fully surrounds the body. For example, the intermediate protruding lip may extend in a planar direction around the (whole) lateral wall of the element. In an embodiment, the element is separated (by etching) out of a body preform (e.g. a panel). Accordingly, the intermediate protruding lip may be present (in the planar direction) around the body (compare Figure 5A). In an embodiment, the surrounding intermediate protruding lip is disrupted, in particular in the planar extension (x, y), by a disrupting surface. Such a disrupting surface may be the relic of a connection structure that may provide the advantage of facilitating the manufacture process.

In the context of the present document, the term "disrupting surface" may in particular refer to a structural feature that remains after a disruption. For example, when the element is formed in a body preform by separation, there may be material spared from the material removal. Said remaining material may function as a connection structure to still connect the (essentially) separated body to the body preform (e.g. in a frame). When the body/element is to be finally separated from the body preform, the connection structure can be disrupted, leaving behind a disrupting surface/profile/structure at the element.

In an embodiment, the disrupting surface comprises a planar surface (in particular a vertical planar surface). In an embodiment, the disrupting surface has a frontal shape delimited by lateral lip-shaped protrusions, and/or is vertically delimited by the main surfaces of the body. The disrupting surface may remain after separation of the element out of a frame (of the body preform) and may therefore be the only region of the element (around the lateral wall) that is free of the intermediate protruding lip. Depending on the disruption process, the disrupting surface may be straight/planar (e.g. routing) or rough/jagged (e.g. from a rip-off).

In an embodiment, the disrupting surface has a different roughness than the surface of the intermediate protruding lip. In an embodiment, the disrupting surface has a different roughness than at least one main surface of the body. This structural feature may be a footprint of a different manufacture process. For example, the roughness of the intermediate protruding lip may be generated by etching, the roughness of the main surface may be unchanged due to a protection layer, and the roughness of the disrupting surface may be caused by the disrupting process (e.g. free of etching).

In an embodiment, the ratio/amount of the peripheral surface of the body that comprises the intermediate protruding lip is higher than the ratio/amount of the peripheral surface of the body that comprises the disrupting surface. Thus, the advantageous intermediate protruding lip may be present at a larger region of the element compared to the disrupting surface.

In an embodiment, at least two disrupting surfaces divide the (surrounding) intermediate protruding lip in two or more sub-portions. In an embodiment, the majority of the peripheral surface of the body comprises the intermediate protruding lip. In an embodiment, the intermediate protruding lip surrounds the body in a direction perpendicular to the thickness direction. For example, the disrupting surface may extend along the lateral wall in the vertical direction (from first main surface to second main surface) and thereby separate the surrounding intermediate protruding lip (in the planar direction). Since the at least two disrupting surfaces may create a complex shape of the lateral wall, an interaction (a joint, double-joint) between the adjacent material, for example the electrically insulating layer structure and/or an embedding material, and the lateral wall occur in a plurality of spatial direction, and thus a reliable embedding of the element may be ensured.

In an embodiment the body comprises two or more layers, in particular stacked layers. This may provide the advantage of a high design flexibility. Additionally or alternatively, it may be easier to create the intermediate protruding lip when the element comprises more layers; especially when the layers comprise different materials, a different respective material removal rate may be inherent, which creates the intermediate protruding lip. In one embodiment, the element comprises a single layer (e.g. copper inlay); for example, the element may be configured as heat sink/heat dissipation for connecting the heat-emitting component. In another embodiment, the element may comprise two or more stacked layers. For example, the element may be configured as a bridge element with multiple layers for component interconnection. In a further embodiment, the element may comprise a (high density) stack for embedding in a (low density) component carrier stack. In another embodiment, the element may comprise an inductive coil embedded in magnetic matrix layers.

In an embodiment, the element further comprises at least one opening inside the body, wherein the at least one opening comprises the respective intermediate protruding lip (compare e.g. Figure 5A). This may provide the advantage of an efficient manufacture process; e.g. by separating the body by etching out of a frame. In another embodiment, an opening (that comprises the intermediate protruding lip from an etching process) may be formed in the final element, e.g. for a specific functionality. In an example, such an opening with a lip inside may further increase stability, e.g. when embedding the element in a component carrier cavity. For example, resin material may flow into the opening and the lip serves as an anchor and distribution means for resin inside the opening.

In an embodiment, the element is embedded in and/or surface mounted to the stack, in particular embedded in an embedding/encapsulation material of the stack. This may provide the advantage that the element can be assembled to the component carrier in a design-flexible manner. For example, if the element should be well protected, the element may be embedded in a cavity. In another example, if the element should provide heat dissipation/sink functionality, the element may be surface-mounted. Depending on the desired application, embedding and/or mounting (e.g. half embedded and half surface-mounted) may have specific advantages.

In an embodiment, an embedding material of the stack at least partially fills the concave portion above and/or below the intermediate protruding lip (in the thickness direction). In an embodiment, this measure increases adhesion/stability between the stack and the element. The concave portion and/or the undercut may serve as a hollow space, into which resin material may flow. Thereby, the element may be stabilized in the cavity compared to straight sidewalls of the prior art (see Figure 3A above).

In an embodiment, the element has at least one of the following functions/functionalities in the stack or component carrier: a heat/thermal function (e.g. a heat dissipation inlay, a copper block, a heat sink), an electric function (e.g. one or more massive traces), a stability function (e.g. an electrically conductive/insulating stabilization material, in particular a metal or a reinforced resin), a magnetic/inductive function (e.g. a magnetic material/matrix, in particular with an embedded induction coil). Thus, a plurality of functionalities may be provided in an efficient and flexible manner to the component carrier, using the element as a versatile inlay.

In an embodiment, the element is at least partially covered by at least one of an adhesion promoter, a metal, a metal oxide, a ceramic, a glass. Such a cover material may provide additional advantageous functionality to the element. For example, an adhesion promoter may enhance the adhesion to insulating material for the stack. In a further example, a metal oxide may increase resilience, e.g. against oxidation. A ceramic or glass cover may improve thermal expansion properties. In an embodiment, the element may be at least partially covered by metal, e.g. copper. In an embodiment, the coating may provide a specific functionality and/or provide a more smooth/rough surface.

In an embodiment, removing the first material and removing the second material is done at the same time, in particular in one step. This may provide the advantage of an efficient and fast manufacture process. For example, the body preform may be placed in an etching bath or transported (by a transport line) through an etching bath. The main surfaces may be covered by a protection layer and only the regions to be etched may be exposed. In this manner, etching from the above (first main surface) and etching from below (second main surface) can be performed in a single step, in particular yielding a central intermediate protruding lip.

In an embodiment, removing the first material and removing the second material is done subsequently, in particular in two steps. This may provide the advantage of specific structural features such as a decentered intermediate protruding lip or different sizes of concave portions or boundary profiles. For example, the first main surface may be etched before etching the second main surface (or vice versa), in particular using different etching parameters.

In an embodiment, removing the first material and/or removing the second material comprises etching, in particular at least one of wet etching, plasma etching. In an embodiment, removing the first material and/or removing the second material is free of mechanical removal/processing, in particular drilling, more in particular free of at least one of mechanical drilling, laser drilling, routing. An etching process may have advantages over a mechanical removal process, for example: faster process, burr-free, better control of dimension tolerances, lower process-cost, elimination of high pressure rinse.

Conventionally, etching has not been considered suitable for thick structures such as a copper inlay of e.g. 800 µm thickness. However, using the described process (that generates the intermediate protruding lip), etching may be used in an efficient and reliable manner, even for thick structures.

In an embodiment, removing the first material and/or removing the second material comprises: forming one or more body/bodies (elements) in the body preform. This may provide the advantage that a plurality of elements can be manufactured in a fast and efficient process. In an example, the body preform may be a copper panel and the single elements may be separated by material removal. In an embodiment, the method comprises: separating the body/bodies from further material of the body preform. The body preform may serve as a frame from which the future elements are separated/isolated.

In an embodiment, the method further comprises: forming at least one opening inside the body, in particular so that the at least one opening comprises the respective intermediate protruding lip. This may provide the advantage that the described material removal process may be used to efficiently separate the bodies from a body preform. In a first embodiment, the opening may be formed around a future element, e.g. using two U-shaped openings. In a second embodiment, such an opening may be formed within an element, e.g. to provide a further functionality.

In an embodiment, removing the first material and/or removing the second material, in particular forming the opening, comprises: forming a connection structure, in particular by not-removing material in the connection structure region, between the body and the further material of the body preform. By this measure, the manufacture process may be well controllable and stable. For example, the connection structure may be disrupted in an easy and straightforward manner. Thus, the semi-finished elements may be also (essentially) separated in the frame, and the final separation may be done by disrupting the connection structure.

In an embodiment, the method further comprises: separating the body, in particular by mechanical separation (e.g. by routing), from the further material of the body preform by disrupting the connection structure, thereby forming a disrupting surface at the body/element. In an embodiment, the disrupting surface is free of the intermediate protruding lip. In other words, the disrupting surface may be formed independently from the intermediate protruding lip. In an embodiment, the disrupting surface is present at the lateral wall, where no intermediate protruding lip is formed.

In an embodiment, the intermediate protruding lip is a footprint from an etching process that is performed from the first main surface and from the opposed second main surface. As described above, the advantageous etching process may generate the intermediate protruding lip that can be used as an efficient anchor for stabilization during embedding of the element.

In an embodiment the method further comprises: adjusting the conditions for removing the first material and/or removing the second material. In an embodiment, the method comprises adjusting etching conditions,
in particular adjusting at least one of etching speed, etching machine transport speed, etching machine parameters, etching solution, etching solution chemical composition. This may provide the advantage that specific structural features may be obtained, while an efficient material removal process is performed. The above described features such as intermediate protruding lip, boundary profile, concave portion, convex shape, vertex, etc. may be specifically formed by accordingly adjusting/tuning the process parameters. In an embodiment, copper chloride may be used as etchant of metal, e.g. copper.

In an exemplary embodiment, the resulting shape of the element (inlay edge) is different from conventional shapes; rather than a straight perpendicular edge obtained by mechanical processing or simple concave/complex form typically obtained by etch-processes, a complex geometry can be obtained. The length of the central protrusion is about 100-150 µm and top/bottom protrusions around 20-50 µm. Other dimensions of length of central protrusion are possible to obtain (range from 0 to 1000 µm by fine tuning of etching process). Additionally, the edge can be coated with standard copper surface treatment for further enhancement of joint strength between resin and copper.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component (in particular the embedded component), which may be surface mounted on and/or embedded in the component carrier, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

Figure 1A illustrates a cross-section of an element, while Figure 1B illustrates a top view on the element, according to an exemplary embodiment of the invention.
Figure 2A shows an image of a peripheral surface of the element, while Figure 2B shows sizes of the peripheral surface, according to an exemplary embodiment of the invention.
Figure 3A illustrates a cross-section of a conventional circuit board and Figure 3B illustrates a component carrier with an embedded element, according to an exemplary embodiment of the invention.
Figure 4 shows elements implemented in a component carrier which is configured as a power device, according to an exemplary embodiment of the invention.
Figure 5A shows a top view on the element under manufacture in a frame, while Figures 5B, 5C, and 5D respectively show a detailed view, according to an exemplary embodiment of the invention.
Figure 6 shows an image of an element with a disruption surface, according to an exemplary embodiment of the invention.

### Detailed Description of the Drawings

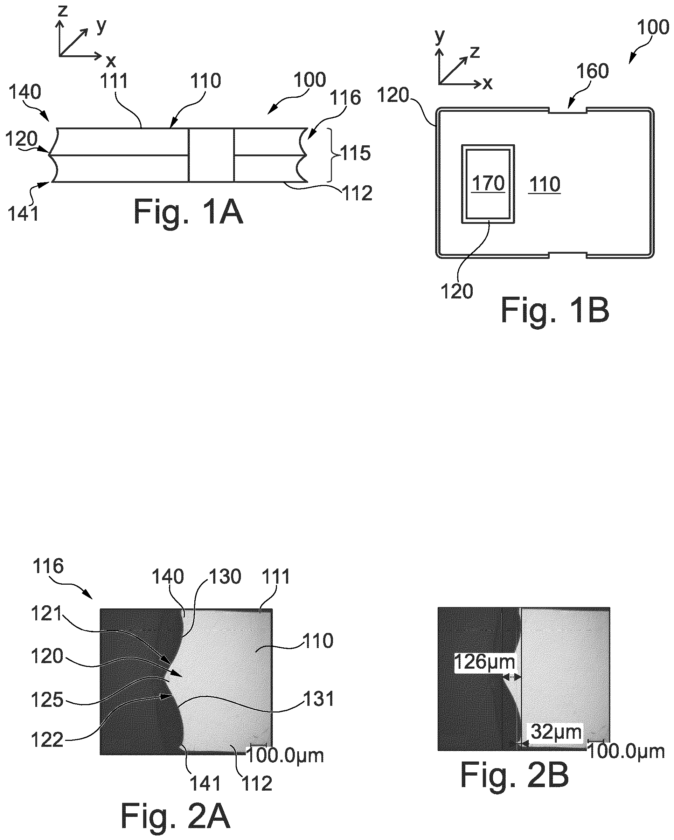

**Figure 1** illustrates a cross-section of an element 100, while **Figure 1B** illustrates a top view on the element 100, according to an exemplary embodiment of the invention.

**Figure 1A****:** the element 100 for a component carrier 200 comprises a body 110 defining two opposed main surfaces (upper main surface 111 and lower main surface 112) and a lateral wall 115 between said two opposed main surfaces 111, 112. The lateral wall 115 defines the peripheral surface 116 of the body 110 and comprises an intermediate protruding lip 120 (nose, protrusion) extending along at least a portion of said peripheral surface 116. The peripheral surface 116 has essentially the shape of the digit "3" along the thickness direction (z) of the element 100. The element 100 is shown to comprise multiple layers (two stacked layers) but can also consist of a single layer. The element 100 comprises a thermally/electrically conductive material, in the examples shown here copper.

The intermediate protruding lip 120 has a rounded, convex shape, in the vertical cross-section (z), i.e. extending along the lateral wall 115. Boundary profiles 140, 141 are defined by the lateral wall 115 and the respective main surfaces 111, 112 of the body 110, in this example an upper first boundary profile 140 defined by the lateral wall 115 and the upper first main surface 111, and a lower second boundary profile 141 defined by the lateral wall 115 and the lower second main surface 112. Each of the boundary profiles 140, 141 is associated to a further protruding lip that extends along at least a portion of the peripheral surface 116 and vertically aligned with the respective main surface 111, 112. The boundary profiles 140, 141 are hence associated to both main surfaces 111, 112 of the body 110 and respectively define rounded protrusions. It can be seen that the planar extension (x, y) of each of the boundary profiles 140, 141 is smaller than the planar extension of the intermediate protruding lip 120 (see left side of the shown element 100). Additionally or alternatively, the planar extension (x, y) of each of the boundary profiles 140, 141 is the same as the planar extension of the intermediate protruding lip 120 (see right side of the shown element 100). These structures result together in a shape of the digit "3". Further additionally or alternatively, the planar extension (x, y) of one of the main surfaces 111 defined by the boundary profile 140 is different from the planar extension (x, y) of the other one of the main surfaces 112 defined by the respective other boundary profile 141.

Such a body 110 of the element 100 is manufactured from a body preform (171, compare Figure 5A) having a plate-like shape and comprising a first main surface 111 and an opposed second main surface 112. During manufacturing, first material is removed in the thickness direction (z+) from the first main surface 111, and second material is removed in the opposed thickness direction (z-) from the second main surface 112. Preferably, the first material from the first main surface 111 and the second material from the main second surface 112 may be the same. Removing the first material and removing the second material is done at the same time or subsequently. The removal comprises etching such as wet etching or plasma etching. The removal is thus free of mechanical removal, in particular drilling such as mechanical drilling, laser drilling, routing, etc. Removing material from the top and bottom yields the specific shape of the protruding intermediate lip 120. This structure remains, for example, when an etching process is performed from the top and from the bottom side. The body 110 has a certain thickness, so that the capacity of the etching to remove material becomes lower with etching depth. During the material removal, for example wet etching, portions of the first main surface 111 and/or second main surface 112, which are not assigned to the opening 170, may be covered by a mask, which prevents material of the body 110 from being removed.

**Figure 1B** show a top view on the element 100 described for Figure 1A. The intermediate protruding lip 120 surrounds the body 110 in a direction perpendicular to the thickness direction (z), but the surrounding intermediate protruding lip 120 is disrupted in the planar extension (x, y) by the disrupting surface 160. The disrupting surface 160 comprises a planar surface and is vertically delimited by the main surfaces 111, 112 of the body 110 (compare Figure 1A). Thereby, the disrupting surfaces 160 divide the intermediate protruding lip 120 into two sub-portions.

As can be seen by the shown Figure 1B, the element 100 comprises two disrupting surfaces 160. The respective two disrupting surfaces 160 are located at the same lateral portion (x) and/or are located at opposed lateral walls (115). Additionally, at least one lateral wall 115, in particular at least two lateral walls 115, is/are free from a disrupting surface 160. Alternatively, each lateral wall may comprise at least one disrupting surface (not shown). The intermediate protruding lip 120 is laterally protruding in comparison with the surface of the disrupting surface 160. Additionally or alternatively, the disrupting surface 160 is composed as a lateral indentation of the lateral wall 115. In another example, the lateral extension of the intermediate protruding lip 120 and the surface of the disrupting surface 160 are flush (see Figure 6). Material removal by the (wet) etching does not affect the disrupting surface 160 of peripheral surface 116 of the body 110, since the area above the disrupting surface 160 is covered by the mask, not allowing etching.

Considering the element 100 as a whole, the ratio/amount of the peripheral surface 116 of the body 110 that comprises the intermediate protruding lip 120 is higher than the ratio/amount of the peripheral surface 116 of the body 110 that comprises the disrupting surface 160. In other words, the majority of the peripheral surface 116 of the body 110 comprises the intermediate protruding lip 120.

At least one opening 170 is located inside the body 110, wherein the at least one opening 170 comprises the respective intermediate protruding lip 120. Preferably, the opening may extend from the first main surface to the second main surface.

**Figure 2A** shows an image of the peripheral surface 116 of the element 100, while **Figure 2B** shows specific distances at the peripheral surface 116, according to an exemplary embodiment of the invention.

**Figure 2A****:** the peripheral surface 116 is essentially shaped as described for Figure 1A above. The intermediate protruding lip 120 is delimited by two concave portions 130, 131, wherein the intermediate protruding lip 120 is arranged between the two concave portions 130, 131 along the thickness direction (z). The two concave portions 130, 131 are in this example essentially similar to each other. The intermediate protruding lip 120 further comprises two straight portions 121, 122 directed towards the external vertex 125 of the intermediate protruding lip 120. The intermediate protruding lip 120 is centered in the thickness direction (z) of the body 110.

Each of the boundary profiles 140, 141 defines an undercut in the thickness direction (z), wherein the undercut at least partially overlaps with the respective concave portion 130, 131. Additionally at least one, in particular two, of the boundary profiles 140, 141 define rounded protrusions. Said rounded protrusions may define further protruding lips.

**Figure 2B****:** the body 110 has a thickness range (z) from 400 µm to 2000 µm, in this example 800 µm. The intermediate protruding lip 120 has a length (distance from the lateral wall) of 126 µm, while the boundary profiles (further protruding lips) have a length of around 32 µm. The intermediate protruding lip 120 has a thickness range from 300 µm to 600 µm and/or the intermediate protruding lip 120 has a thickness range from 30% to 80% with respect to the total thickness of the body 110. Additionally, as can be seen by Figure 2B, the intermediate protruding lip 120 is decentered in the thickness direction (z) of the body.

**Figure 3B** illustrates a component carrier 200 with an embedded element 100, according to an exemplary embodiment of the invention. The component carrier 100 is configured as a printed circuit board (PCB) and comprises a stack 201 that has alternating electrically conductive layer structures 204 and electrically insulating layer structures 202. A cavity has been formed in the stack 201 and the element 100, as described above, has been placed into said cavity. Then, the element 100 has been encapsulated in an embedding material 205 of the stack 201. The first main surface 111 and the second main surface 112 of the body 110 are at least partially, in particular fully, covered by the embedding material 205. Alternatively, at least one main surface of the body may at least be partially free from coverage of the embedding material (not shown).

The embedding material 205 of the stack 201 fills the concave portions 130, 131 above and below the intermediate protruding lip 120, thereby increasing adhesion between the stack 201 and the element 100 (in comparison to the conventional thermal device 310 with straight sidewalls in Figure 3A) (e.g. due to double joint formation, surface treatment of edges, enlarged contact surface between the element and the embedding material 205 and mechanical locking of higher roughness of the contact surface). The element 100 can be used in a flexible manner and can have for example at least one of the following functions in the stack 201: a heat function, an electric function, a stability function, a magnetic function. In the case of a copper element 100, the function can be e.g. heat dissipation. The element 100 can be covered by a cover material such as an adhesion promoter, a metal oxide, or a ceramic (not shown).

**Figure 4** shows two of the above described elements 100 implemented in a component carrier 200 configured as a power device, according to an exemplary embodiment of the invention. Like the component carrier 200 described for Figure 3B, the component carrier 200 of Figure 4 comprises a stack 201 with a plurality of electrically insulating layer structures 202 and electrically conductive layer structures 204. Yet, the component carrier 200 of Figure 4 is much more complex and comprises a central portion 203. Two electronic components 210 are embedded side by side in the central portion 203. A first electrically and thermally conductive first layer structure 220 is arranged on one side of the central portion 203 and a second electrically and thermally conductive second layer structure 220 is arranged on an opposing other side of the central portion 203, each of said first electrically and thermally layer structure 220 and said second electrically and thermally layer structure 220 having a thickness higher than a thickness of the at least one electrically conductive layer structure 204 of the central portion 203 and/or the central portion 203.

The two electronic components 210 (e.g. a die, a MOSFET, etc.) embedded in the central portion 203 are electrically connected with each other by the electrically conductive layer structures 204, in particular forming a half-bridge. One of the elements 100 is embedded in the first electrically and thermally layer structure 220 (and embedded in first embedding material 205), while the other element 100 is embedded in the second electrically and thermally layer structure (and embedded in respective second embedding material 205).

Each of the respective electronic components 210 is connected to at least one element 100. At least one electrically conductive layer structure 204 may be a part of the connection between the electronic component 210 and the at least one element 100. Additionally or alternatively, a sinter material and/or a layer comprising sinter material may be an(other) part of the connection between the electronic component 210 and the at least one element 100.

In such a power application, the elements 100 can serve for mechanical stabilization of the component carrier 100 and provide an efficient heat removal (since power transistors generally produce a high amount of heat).

**Figure 5A** shows a top view on the element 100 under manufacture in a frame 171, while **Figure 5B, Figure 5C, and Figure 5D** respectively show a detailed view, according to an exemplary embodiment of the invention.

**Figure 5A** shows a top view on a part of a body preform 171 for forming a plurality of elements 100. The body preform 171 comprises the first main surface 111 and the opposed second main surface 112. First material is removed from the first main surface 111 and second material is removed from the second main surface 112 in the opposed direction. In this manner, openings 170 are formed inside the body preform 171 in the shape of the letter "U". The respective openings 170 do not completely surround the element bodies 110, because a part of the material is left during the material removal process. The remaining material 161 corresponds to the disrupting surfaces 160. Hereby, the intermediate protruding lip 120 is formed in each lateral wall of the openings 170, at the element bodies 110 as well as at the body preform (frame) 172.

**Figure 5B** shows a detailed view onto a single element body 110. The intermediate protruding lip 120, after formation of the opening 170, can be clearly seen. Additionally, the disrupting surface 160 is laterally protruding in comparison with the surface of the intermediate protruding lip 120.

**Figure 5C** and **Figure 5D****:** these microscopic images show in more detail the intermediate protruding lip 120 of the body 110 after formation of the openings 170. As can be seen by Figure 5C and Figure 5D, the roughness of the intermediate protruding lip 120 is different from the roughness of at least one of the main surfaces 111 of the body 110.

**Figure 6** shows a side image of an element 100 with a disruption surface 160, according to an exemplary embodiment of the invention. Starting from the body preform 171 of Figure 5A, the single bodies 110 can be separated from the frame by disrupting the respective disrupting surfaces 160. As can be seen in Figure 6, such a disrupted disrupting surface 160 remains in the final product and separates the surrounding intermediate protruding lip 120 in the horizontal direction (x, y) into sub-portions.

The disrupting surface 160 comprises a planar surface, in particular having a frontal shape delimited by lateral lip-shaped protrusions, in particular (a portion of) the intermediate protruding lip 120, and/or vertically delimited by the main surfaces 111, 112 of the body 110. Additionally or alternatively, a (seamless) transition from the protruding lip 120 into the disrupting surface 160 is shown. The intermediate protruding lip 120 has a non-constant vertical position along the respective extension of the peripheral surface 116. Additionally or alternatively, the disrupting surface 160 has a different roughness than the surface of the intermediate protruding lip 120. Optionally, the disrupting surface may have a different roughness than at least one main surface of the body (not shown).

### Reference signs

- 100: Element
- 110: Body
- 111: First main surface
- 112: Second main surface
- 115: Lateral wall
- 116: Peripheral surface
- 120: Intermediate protruding lip
- 121: First straight portion
- 122: Second straight portion
- 125: Vertex/edge
- 130: First concave portion
- 131: Second concave portion
- 140: First boundary profile
- 141: Second boundary profile
- 160: Disrupting surface
- 161: Connection structure
- 170: Opening
- 171: Body preform
- 172: Intermediate protruding lip at body preform
- 200: Component carrier
- 201: Stack
- 202: Electrically insulating layer structure
- 203: Central portion
- 204: Electrically conductive layer structure
- 205: Embedding material
- 210: Electronic component
- 220: Electrically and thermally layer structure

## Claims

1. An element (100) for a component carrier (200), comprising a body (110) defining two opposed main surfaces (111, 112) and a lateral wall (115) between said two opposed main surfaces (111, 112);
wherein the lateral wall (115) defines the peripheral surface (116) of the body (110); and
wherein the lateral wall (115) comprises an intermediate protruding lip (120) extending along at least a portion of said peripheral surface (116).

2. The element (100) according to claim 1,
wherein the element (100) comprises or consists of a thermally/electrically conductive material; and/or
wherein the element (100) comprises or consists of an inorganic material, in particular at least one of metal, in particular copper or aluminum, ceramic, glass.

3. The element (100) according to one of the preceding claims,
wherein the element (100) is configured as or configured for at least one of: a printed circuit board, an IC substrate, an interposer, a bridge element.

4. The element (100) according to one of the preceding claims,
wherein the intermediate protruding lip (120) has a rounded shape, in particular a convex shape, in the vertical cross-section (z).

5. The element (100) according to one of the preceding claims,
wherein the intermediate protruding lip (120) is delimited by two concave portions (130, 131),
in particular wherein the intermediate protruding lip (120) is arranged between the two concave portions (130, 131),
more in particular along the thickness direction (z).

6. The element (100) according to one of the preceding claims,
wherein the intermediate protruding lip (120) comprises two straight portions (121, 122) directed towards the external vertex (125) of the intermediate protruding lip (120).

7. The element (100) according to one of the preceding claims,
wherein a boundary profile (140, 141) is defined by the lateral wall (115) and the respective main surfaces (111, 112) of the body (110),
in particular wherein the boundary profile (140, 141) is associated to a further protruding lip that extends along at least a portion of the peripheral surface (116),
more in particular vertically aligned with the respective main surface (111, 112).

8. The element (100) according to claim 7,
wherein the size, in particular the planar extension, of the boundary profile (140, 141) is smaller than the size, in particular planar extension, of the intermediate protruding lip (120); and/or
wherein the boundary profile (140, 141) defines an undercut in the thickness direction (z),
in particular wherein the undercut at least partially overlaps with the respective concave portion (130, 131).

9. The element (100) according to claim 7 or claim 8,
wherein the planar extension (x, y) of one of the main surfaces (111) defined by the boundary profile (140) is different from the planar extension (x, y) of the other one of the main surfaces (112) defined by a respective other boundary profile (141).

10. The element (100) according to one of the preceding claims,
wherein the intermediate protruding lip (120) is decentered in the thickness direction (z) of the body (110); and/or
wherein the intermediate protruding lip (120) has a non-constant vertical position along the respective extension of the peripheral surface (116).

11. The element (100) according to one of the preceding claims,
wherein the intermediate protruding lip (120) partially surrounds the body (110), and
wherein the surrounding intermediate protruding lip (120) is disrupted, in particular in the planar extension (x, y), by a disrupting surface (160),
in particular
wherein the disrupting surface (160) comprises a planar surface, in particular having a frontal shape delimited by lateral lip-shaped protrusions, and/or vertically delimited by the main surfaces (111, 112) of the body (110); and/or
wherein the disrupting surface (160) has a different roughness than the surface of the intermediate protruding lip (120); and/or
wherein the disrupting surface (160) has a different roughness than at least one main surface (111, 112) of the body (110).

12. A component carrier (200) comprising a stack (201) comprising at least one electrically conductive layer structure (204) and at least one electrically insulating layer structure (202),
wherein the component carrier (200) further comprises an element (100) according to one of the preceding claims 1 to 11,
in particular wherein the element (100) is embedded in and/or surface mounted to the stack (201),
more in particular embedded in an embedding material (205) of the stack (201).

13. A method of manufacturing an element (100), in particular according to one of the claims 1 to 11, the method comprising:
providing a body preform (171), in particular having a plate-like shape, that comprises a first main surface (111) and an opposed second main surface (112);
removing first material in the thickness direction (z+) from the first main surface (111), and
removing second material in the opposed thickness direction (z-) from the second main surface (112), so that
a body (110) is provided,
wherein a lateral wall (115) is formed between the first main surface (111) and the second main surface (112) that defines the peripheral surface (116) of said body (110), and
wherein the lateral wall (115) comprises an intermediate protruding lip (120) extending along at least a portion of said peripheral surface (116).

14. The method according to claim 13,
wherein removing the first material and removing the second material is done at the same time, in particular in one step, or wherein removing the first material and removing the second material is done subsequently, in particular in two steps; and/or
wherein removing the first material and/or removing the second material comprises etching, in particular at least one of wet etching, plasma etching; and/or
wherein removing the first material and/or removing the second material is free of mechanic removal, in particular drilling, more in particular free of at least one of mechanical drilling, laser drilling, routing.

15. A method of manufacturing a component carrier (200), the method comprising:
providing a stack (201) comprising at least one electrically conductive layer structure (204) and at least one electrically insulating layer structure (202);
assembling, in particular embedding and/or surface-mounting, an element (100) according to one of the claims 1 to 11 and/or manufactured according to claim 13 or claim 14 to the stack (201).
